# EUROPÄISCHE PATENTSCHRIFT

(11) **EP 1 825 511 B1**
(45) Veröffentlichungstag und Bekanntmachung des Hinweises auf die Patenterteilung: **23.11.2011**
(21) Anmeldenummer: 04802956.5
(22) Anmeldetag: 17.12.2004
(51) Int. Cl.: H01L 23/48, H01L 21/60, H01L 25/07

(54) **HALBLEITERSCHALTMODUL**
SEMICONDUCTOR SWITCHING MODULE
MODULE DE COMMUTATION A SEMICONDUCTEURS

(43) Veröffentlichungstag der Anmeldung: 29.08.2007
(73) Patentinhaber: SIEMENS AKTIENGESELLSCHAFT, 80333 München (DE)
(72) Erfinder: APFELBACHER, Walter, 92271 Freihung (DE); REICHENBACH, Norbert, 92224 Amberg (DE); SEITZ, Johann, 92224 Amberg (DE)
(86) Internationale Anmeldenummer: PCT/DE2004/002770
(87) Internationale Veröffentlichungsnummer: WO 2006/063539

(56) Entgegenhaltungen:
- EP-A- 0 285 074
- EP-A- 1 318 545
- EP-A- 1 391 966
- WO-A2-03/030247
- DE-A1- 10 121 970
- DE-A1- 10 350 770
- DE-A1- 19 707 514
- DE-C1- 19 617 055
- FR-A- 1 484 261
- US-A- 5 635 427

## Beschreibung

Die vorliegende Erfindung betrifft ein Halbleiterschaltmodul gemäß dem Oberbegriff des Anspruchs 1.

Halbleiterschaltmodule kommen dann zur Anwendung, wenn es darum geht, bei Betriebsspannungen von einigen hundert Volt, Lastströme bis zu mehreren Hundert Ampere häufig und nahezu geräuschlos zu schalten.

Aus der DE 196 17 055 Cl ist ein Halbleiterschaltmodul mit einem Leistungshalbleiterelement, das eine Basisschicht, eine Kupferschicht zumindest einen auf der Kupferschicht angebrachten Leistungshalbleiterchip sowie eine weitere elektrisch leitende, und zumindest einen Lastanschluss des Leistungshalbleiterchips überdeckende Schicht, bekannt. Ferner sind Mittel offenbart, womit ein sicheres Anschließen des Lastanschlusses an einen zu schaltenden Laststromkreis ermöglicht wird.

Aus der DE 101 21 970 A1 ist ein Leistungshalbleitermodul, bestehend aus einem Gehäuse, einem keramischen Substrat, schaltungsgerecht darauf angeordneten strukturierten und elektrisch leitenden Kontaktflächen, darauf angeordneten Bauelementen, einer Druckkontaktierung, bestehend aus einem flexiblen Druckspeicher sowie einer den Druck erzeugenden Druckplatte, sowie Leistungs- und Steueranschlüssen bekannt.

Halbleiterschaltmodule können dabei beispielsweise nach der so genannten Bonding-Technologie hergestellt werden. Dabei wird das eigentliche Leistungshalbleiterelement, bestehend aus einem Basissubstrat und dem darauf angebrachten Leistungshalbleiterchip sowie weiterer Bauelemente, über entsprechende Bonding-Drähte mit Anschlusselementen verbunden. Diese Anschlusselemente sind durch das Modulgehäuse des Halbleiterschaltmoduls nach außen geführt, so dass eine entsprechende Beschaltung mit dem zu schaltenden Laststromkreis vorgenommen werden kann. Zur elektrischen Isolation sowohl der Bauelemente als auch der Bonding-Drähte wird ein Großteil des Innenraums des Modulgehäuses mit einer isolierenden Vergussmasse aufgefüllt. Zur Wärmeabfuhr ist zudem auf der Seite des Basissubstrats, die der Seite mit dem Leistungshalbleiterchip gegenüberliegt, ein entsprechend dimensionierter Kühlkörper angebracht.

Alternativ kann das Leistungshalbleiterelement eines solchen Halbleiterschaltmoduls auch nach der so genannten Planar-Technologie aufgebaut werden. Solch ein planarer Aufbau eines Leistungshalbleiterelements ist beispielsweise aus der WO 03/030247 bekannt. Hier werden die Bauelemente auf dem Basissubstrat, das aus einer Keramikbasis mit beidseitig aufgebrachten Kupferschichten besteht, angebracht. Über weitere auf die Oberfläche aufgebrachte Schichten aus elektrisch isolierenden und elektrisch leitenden Materialien können die Bauelemente dann flächig und ohne zusätzliche Drähte miteinander kontaktiert oder mit Anschlusselementen verbunden werden. Durch die Verwendung solcher in Planar-Technologie ausgeführter Leistungshalbleiterelemente entfallen weitgehend die bei der Bonding-Technologie, aber auch die bei der herkömmlichen Löttechnik, benötigten Verdrahtungen. Die Isolation zwischen den einzelnen Bauelementen und den elektrisch leitenden Schichten wird hier zudem alleine von den elektrisch isolierenden Schichten bewirkt, so dass auf eine zusätzliche Vergussmasse verzichtet werden kann. Die elektrisch isolierenden Schichten dienen somit, insbesondere dann, wenn sie sich nahezu über die gesamte Oberfläche des Leistungshalbleiterelements erstrecken, zur Erhöhung der Kriechstrecken zwischen den verschiedenen leitenden Schichten und Bauelementen. Somit können Halbleiterschaltmodule kompakter, weniger aufwändig und damit auch kostengünstiger hergestellt werden.

Leistungshalbleiterchips in Halbleiterschaltmodulen, beispielsweise als Thyristoren ausgebildet, weisen zum Schalten der Lastströme einen Steueranschluss auf, an den ein Steuersignal angelegt wird. In Abhängigkeit von diesem Steuersignal wird dann ein, über einen Lastanschluss und eine Basis des Leistungshalbleiterchips geführter Laststrom gesteuert und damit geschaltet. Das Anschließen des Laststromkreises und des Steuersignals kann dabei mittels der zuvor beschriebenen Bonding- oder Planar-Technologie erfolgen. Das Anschließen mittels der Bonding-Technologie hat aber den Nachteil, dass es sehr aufwändig ist. Das Anschließen ausschließlich mittels Planar-Technologie hat den Nachteil, dass die planaren elektrisch leitenden Schichten zum Verbinden der Last- und Steueranschlüsse Teile der Oberfläche des Leistungshalbleiterelements überdecken und damit komplexe und aufwändige planare Strukturen entstehen.

Aufgabe der vorliegenden Erfindung ist es, ein Halbleiterschaltmodul anzugeben, bei dem das Anschließen der Lastanschlüsse, aber auch der Steueranschlüsse insgesamt weniger aufwändig ist.

Diese Aufgabe wird gelöst durch ein Halbleiterschaltmodul gemäß Anspruch 1.

Das erfindungsgemäße Halbleiterschaltmodul ermöglicht so ein einfaches Anschließen des zu schaltenden Laststromkreises an den Lastanschluss des Leistungshalbleiterchips. Die erfindungsgemäß dafür vorgesehenen Mittel ermöglichen eine Druckkontaktierung zum sicheren Anschließen, die weniger aufwändig ist als bekannte Bond- oder Lötverbindungen.

Die in Planar-Technologie hergestellte weitere elektrisch leitende Schicht, die insbesondere aus Kupfer bestehen kann, dient dabei zusätzlich als Oberflächenschutz für die Anschlüsse des Leistungshalbleiterchips. Dies gilt insbesondere für den Lastanschluss, der durch die Druckkontaktierung entsprechend beansprucht wird. Zudem kann mit der weiteren elektrisch leitenden Schicht eine sehr plane Oberfläche erzeugt werden, die eine sichere ganzflächige Auflage für die Kontaktfläche der Mittel gewährleistet.

Die flächenartige Druckkontaktierung in Verbindung mit einem in Planar-Technologie hergestellten Leistungshalbleiterelement hat damit gegenüber den punktartigen Verbindungsarten Bonden und Löten den Vorteil einer deutlich höheren Lastwechselfestigkeit. Dies ist insbesondere für Anwendungen mit kurzzeitig hohen Belastungen wichtig, wie sie beispielsweise bei Sanftstartern gegeben sind.

Um einen möglichst kleinen Übergangswiderstand zu erreichen, weist die Kontaktfläche vorzugsweise eine Flächenform auf, die mit einer Flächenform des Lastanschlusses korrespondiert. Durch diese, dann mit maximal möglicher Kontaktfläche, bewirkte Druckkontaktierung wird ein verlustarmer Stromübertritt zwischen dem Lastanschluss des Leistungshalbleiterchips und dem daran anzuschließenden Laststromkreis erreicht. Somit können die beispielsweise bei Bondverbindungen üblichen Begrenzungen in der Stossstrombelastbarkeit vermieden werden.

Bevorzugt wird die Druckkontaktierung direkt auf dem Leistungshalbleiterchip erfolgen. So kann das Leistungshalbleiterelement genau am Ort des Leistungshalbleiterchips auf einen, an der gegenüberliegenden Seite des Leistungshalbleiterelements angebrachten, Kühlkörper gedrückt werden. Dadurch wird gerade am Ort des Leistungshalbleiterchips ein optimaler thermischer Kontakt zwischen der Keramik des Leistungshalbleiterelements und dem Kühlkörper erzielt. Damit lässt sich eine sehr gute Verlustleistungsabfuhr vom Leistungshalbleiterchip hin zum Kühlkörper erreichen.

Erfolgt die Druckkontaktierung dagegen auf dem Leistungshalbleiterelement neben dem Leistungshalbleiterchip, so muss die weitere elektrisch leitende Schicht so über die Oberfläche des Leistungshalbleiterchips hinaus ausgedehnt sein, dass mit der Kontaktfläche ein flächiger Kontakt neben dem Leistungshalbleiterchip herstellbar ist, wobei zwischen dieser elektrisch leitenden Schicht und der Oberfläche der darunter liegenden Kupferschicht und des Leistungshalbleiterchips eine elektrisch isolierende Schicht angeordnet ist, die an der Stelle, an der sich der Lastanschluss des Leistungshalbleiterchip befindet, ein Fenster aufweist, um eine elektrische Kontaktierung zwischen der weiteren elektrisch leitenden Schicht und dem Lastanschluss herzustellen.

Da in vielen Fällen am Leistungshalbleiterchip der Lastanschluss und der Steueranschluss so angeordnet sind, dass letzterer vom Lastanschluss umschlossen ist, kann mit der Druckkontaktierung neben dem Leistungshalbleiterchip eine räumliche Trennung zwischen den Kontaktmitteln für den Last- und Steueranschluss erreicht werden.

In einer bevorzugten Ausbildung des erfindungsgemäßen Halbleiterschaltmoduls umfassen die Mittel zumindest ein Kontaktmittel sowie Vorspannmittel, wobei die Vorspannmittel das zumindest eine Kontaktmittel mit seiner Kontaktfläche flächig auf die weitere elektrisch leitende Schicht aufdrücken. Dadurch ist eine besonders einfache Montage des Halbleiterschaltmoduls mit wenigen Bauelementen gewährleistet.

Sollen der Last- und der Steueranschluss räumlich zusammenliegen, so muss, insbesondere bei der direkten Kontaktierung des Leistungshalbleiterchips, das Kontaktmittel als Hohlkörper zum Aufnehmen eines Kontaktmittels für den Steueranschluss ausgebildet sein. Damit kann das Leistungshalbleiterelement und damit auch das Halbleiterschaltmodul insgesamt kleiner werden, da keine zusätzlichen Flächen neben dem Leistungshalbleiterchip für die Kontaktierung notwendig sind.

Schiefstellungen zwischen der Oberfläche des Lastanschlusses und der Kontaktfläche des Kontaktmittels können zu einer Verringerung dieser miteinander in Verbindung stehenden Flächen und damit zu einer Erhöhung des Übergangswiderstandes des Kontaktes führen. Dies kann vermieden werden, indem das Kontaktmittel beispielsweise zweiteilig ausgebildet ist, wobei die beiden Teile dabei mit einer Wölbungsfläche aneinander zum Liegen kommen. Die Wölbung erlaubt, dass die beiden Teile relativ zu einander so zum Liegen kommen, dass ein sicherer Flächenkontakt erreicht wird.

Durch die Ausbildung von zumindest einer Verjüngung am Kontaktmittel, insbesondere zwischen einer Auflage des Kontaktmittels am Modulgehäuse und der eigentlichen Kontaktfläche, können auftretende Schiefstellungen durch die erhöhte Flexibilität an diesen Verjüngung noch besser ausgeglichen werden.

Zudem kann das Kontaktmittel aus weichgeglühtem Kupfer bestehen. Aufgrund seiner geringeren Härte kann es dann auch bei geringen Schiefstellungen nachgeben und sich an die Kontaktfläche anschmiegen.

Vorzugsweise ist das Vorspannmittel als Bügel ausgebildet, der insbesondere an der Stelle, an der er mit dem Kontaktmittel in Berührung kommt, eine Auswölbung aufweist. Durch die gekrümmte Oberfläche der Auswölbung wird vom Vorspannmittel eine punktuelle Kraft direkt auf das Kontaktmittel ausgeübt. Dadurch wird eine sichere Kontaktierung erreicht, und zudem auch ein Ausgleich von Schiefstellungen ermöglicht.

Weisen die Vorspannmittel Befestigungsmittel auf, mit denen der Bügel beispielsweise an einem Modulgehäuse befestigt wird, wird erst mit dem Anziehen der Befestigungsmittel von dem Vorspannmittel Druck auf das Kontaktmittel ausgeübt.

Alternativ können die Befestigungsmittel auch so vorgesehen sein, dass der Bügel direkt mit dem Leistungshalbleiterelement verbunden wird, womit dann auf ein Modulgehäuse verzichten werden kann. Leistungshalbleiterelement, Kontaktmittel und Vorspannmittel bilden dann eine Einheit, die fertig montiert schon eine zuverlässige Druckkontaktierung und damit eine funktionsfähiges Halbleiterschaltmodul darstellt. Anstelle des Bügels kann das Vorspannmittel selbst auch Teil des Modulgehäuses des Halbleiterschaltmoduls sein. Durch den Wegfall der ansonst zusätzlichen Vorspannmittel kann das Halbleiterschaltmodul kostengünstiger hergestellt werden.

In einer weiteren Ausführungsform sind Kontaktmittel und Vorspannmittel einstückig als ein federndes Element ausgebildet. Das heißt, die Kontaktierung und die Druckbeaufschlagung erfolgen über ein einziges Bauelement. Damit wird wiederum ein kostengünstigeres Halbleiterschaltmodul erzielt.

Ist das Kontaktmittel zudem massiv ausgebildet, so kann es als Kurzzeitwärmespeicher dienen. Insbesondere bei Anwendungen, in denen kurzzeitig sehr hohe Verluste auftreten, kann damit die Temperatur des Leistungshalbleiterchips weiterhin in einem zulässigen Bereich gehalten werden. Im Gegensatz zur Lötseite des Leistungshalbleiterchips, bei der die Wärme erst durch die vergleichsweise schlecht wärmeleitende Keramik fließen muss, um zum Kühlkörper zu gelangen, ist das Kontaktmittel mit nur minimalem thermischem Widerstand an die Oberseite des Leistungshalbleiterchips angeschlossen und kann damit sehr effektiv kurzzeitig hohe Verlustleistungen abpuffern. Die Hauptkühllast wird dabei aber weiterhin von dem Kühlkörper übernommen, der auf der Seite des Leistungshalbleiterelements vorgesehen ist, die der Seite mit dem Leistungshalbleiterchip gegenüber liegt. Der Kühlkörper kann dann aber kleiner dimensioniert werden.

Die Erfindung sowie vorteilhafte Ausführungsbeispiele derselben werden im Weiteren anhand der nachfolgenden Figuren näher beschrieben. Es zeigen:
- FIG 1: eine schematische Darstellung einer ersten Ausführungsform des erfindungsgemäßen Halbleiterschaltmoduls,
- FIG 2: eine schematische Darstellung einer zweiten Ausführungsform,
- FIG 3: eine schematische Darstellung einer dritten Ausführungsform,
- FIG 4: eine schematische Darstellung einer vierten Ausführungsform,
- FIG 5: in schematischer Darstellung eine Draufsicht auf Teile der vierten Ausführungsform.

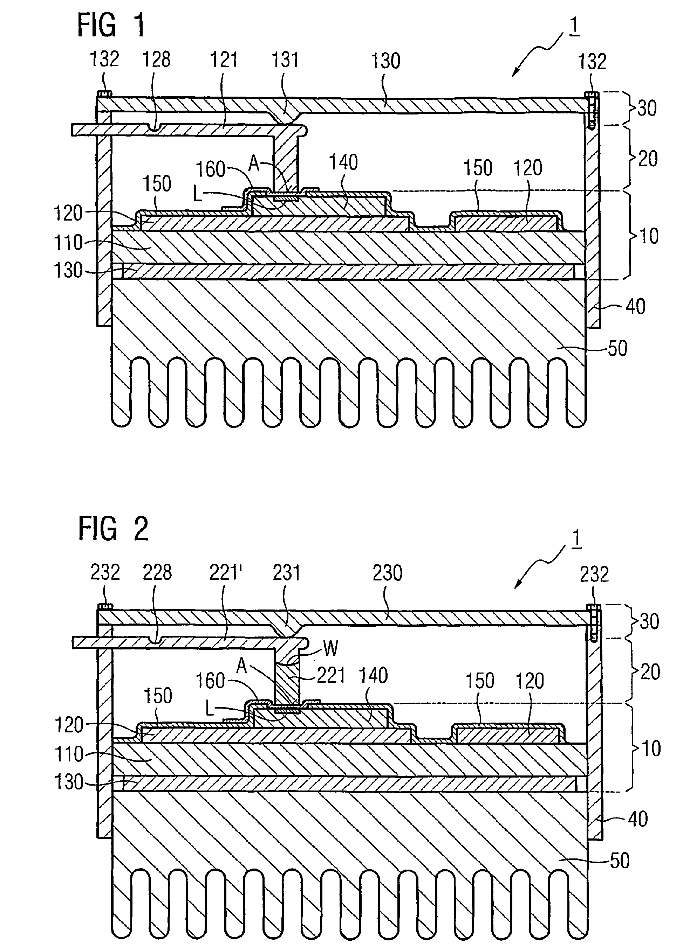

In FIG 1 ist schematisch ein erfindungsgemäßer Aufbau eines Halbleiterschaltmoduls 1 dargestellt, so wie es beispielsweise bei Sanftstartern Verwendung finden würde. Das erfindungsgemäße Halbleiterschaltmodul umfasst dabei ein Leistungshalbleiterelement 10, sowie Mittel 20 und 30 zum sicheren Anschließen des Lastanschlusses L an einen nicht näher dargestellten Laststromstromkreis. Im vorliegenden Beispiel weist das Halbleiterschaltmodul zudem noch ein Gehäuse 40 sowie einen Kühlkörper 50, zum Abführen der von einem Leistungshalbleiterchip 140 bewirkten Wärme, auf.

Grundlage für die vorliegende Erfindung ist das in Planar-Technölogie aufgebaute Leistungshalbleiterelement 10, so wie es beispielsweise aus der WO 03/030247 bekannt ist. Das Leistungshalbleiterelement besteht dabei aus einem Keramikträger 110 mit zwei Kupferplattierungen 120 und 130. Auf der Kupferschicht 120 ist der Leistungshalbleiterchip 140 aufgelötet.

Mit einer Isolierfolie 150, die auch mit der Planar-Technologie aufgebracht wird, werden zumindest Teile der Oberfläche des Leistungshalbleiterchips 140 und der Kupferplattierung 120 abgedeckt. Am Ort des Lastanschlusses L des Leistungshalbleiterchips 140 weist diese elektrisch nicht leitende Schicht 150 ein Fenster auf, so dass der Lastanschluss L freigelegt ist.

Auf der Isolierfolie 150 und dem freigelegten Bereich des Leistungshalbleiterchips 140 wird wiederum mittels Planar-Technologie eine weitere elektrisch leitende Schicht 160 aufgebracht. Typische Schichtdicken dieser elektrisch leitenden Schicht 160, die vorzugsweise auch aus Kupfer besteht, betragen dabei 100 - 200 µm.

Zur Vergrößerung von Luft- und Kriechstrecken zwischen der elektrisch leitenden Schicht 160 und weiteren leitenden Schichten oder Bauelementen kann wiederum eine, nicht näher dargestellte, Isolierfolie mittels Planar-Technologie aufgebracht sein.

Durch solche elektrisch isolierenden Schichten, die gegebenenfalls bis zum Rand des Leistungshalbleiterelements geführt sind, lassen sich somit generell die Kriechstrecken zwischen den verschiedenen Schichten und/oder zwischen verschiedenen auf dem Leistungshalbleiterelement aufgebrachten elektrischen Bauelementen verringern. Durch diese horizontal und vertikal bewirkten Isolierungen lassen sich somit die Abmaße des Leistungshalbleiterelements verringern, was dann zu einem kompakteren Halbleitermodul führt.

Erfindungsgemäß sind nun Mittel 20 und 30 zum sicheren Anschließen des Lastanschlusses L an den vom Leistungshalbleiterchip 140 zu schaltenden Laststromkreis vorgesehen. Im konkreten Ausführungsbeispiel wird nun über die Mittel 30 das elektrisch leitende Kontaktmittel 121 mit seiner Kontaktfläche A auf die elektrisch leitende Schicht 160, die sich direkt über dem Lastanschluss L befindet, aufgedrückt. Im vorliegenden Ausführungsbeispiel erfolgt dies insbesondere mittels eines Bügels 130, der mit mehreren Befestigungsmitteln, hier zwei Schrauben 132, mit dem Modulgehäuse 40 verschraubt ist und der eine Auswölbung 131 aufweist.

Beim Zusammenbau des Halbleiterschaltmoduls kann es, beispielsweise aufgrund von Maßtoleranzen der einzelnen Bauelementen, zu Schiefstellungen zwischen dem Leistungshalbleiterelement 10, den Mitteln 20 und 30, dem Modulgehäuse 40 und dem Kühlkörper 50 kommen. Dadurch wird sich die in aller Regel doch großflächige Kontaktfläche A unter Umständen nicht mehr ganzflächig auf die weitere elektrisch leitende Schicht 160 aufdrücken, was zu einem erhöhten elektrischen Kontaktwiderstand und damit zu erhöhten thermischen Verlusten des Leistungshalbleiterchips 140 führt. Zur Vermeidung einer solchen Schiefstellung ist in dem in FIG 1 dargestellten Ausführungsbeispiel beim Kontaktmittel 121 eine Verjüngung 128 vorgesehen. Ebenso sind andere Maßnahmen, wie beispielsweise die Verwendung von weichgeglühtem Kupfer als Material für das Kontaktmittel 121 möglich. Zudem ist der Bügel 130 mit einer Auswölbung 131 versehen, um ein punktuelles Aufdrücken und damit sicheres Kontaktieren des Kontaktmittels 121 mit der weiteren, elektrisch leitenden Schicht 150 zu gewährleisten.

Generell sind anstelle des Bügels auch weitere konstruktive Lösungen als Vorspannmittel zum Druckkontaktieren des Kontaktmittels vorstellbar. So könnten anstelle des Bügels Gehäuseteile des Modulgehäuses entsprechend ausgebildet sein, die beim Zusammenbau das Kontaktmittel auf das Leistungshalbleiterelement aufdrücken und damit die Druckkontaktierung bewirken. Je nach Ausführungsform des Halbleiterschaltmoduls erfolgt somit die Druckkontaktierung auf unterschiedlichste Art und Weise.

Ein zweites Ausführungsbeispiel ist in FIG 2 dargestellt. Hier ist das Kontaktmittel zweiteilig ausgebildet: Durch eine entsprechende Formgebung der Wölbungsfläche W der beiden Teileelemente 221 und 221' wird eine ausreichende Beweglichkeit zum Ausgleich eventueller Schiefstellungen zwischen Kontaktmittel 221 und dem Leistungshalbleiterelement 10 erreicht.

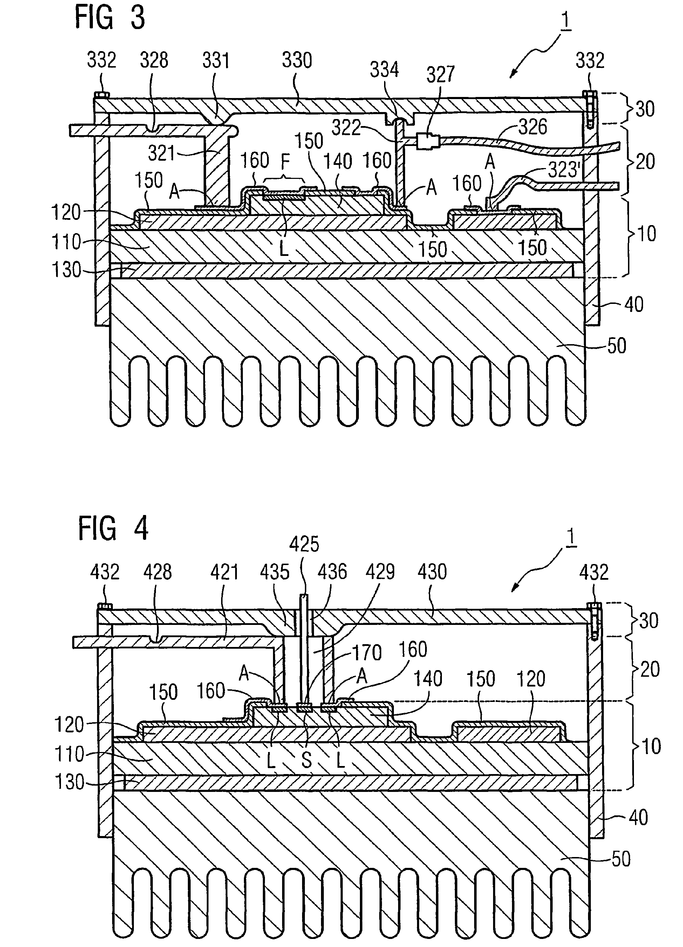

In FIG 3 sind verschiedene weitere erfindungsgemäße Kontaktmittel und Vorspannmittel dargestellt. So kann beispielsweise die Druckkontaktierung mittels eines Kontaktmittels 321 und den Vorspannmitteln 30, anstelle auf der Oberseite des Leistungshalbleiterchips 140, auch neben dem Leistungshalbleiterchip 140 erfolgen. Dazu wird die elektrische leitende Schicht 160 über den Leistungshalbleiterchip 140 hinaus weitergeführt. Die Kontaktierung zwischen Kontaktmittel 321 und Lastanschluss L erfolgt auch hier über die weitere elektrisch leitende Schicht 160.

Mit dem Kontaktmittel 322 ist in FIG 3 eine weitere Ausführungsform dargestellt. Das hier mehr stabförmig ausgeführte Kontaktmittel 322 weist dabei einen entsprechenden Anschluss 327 zum Anschließen eines elektrischen Leiters 326 auf. Über diesen, durch das Modulgehäuse 40 geführten Leiter 326 kann das Kontaktmittel 322 dann von außen beschaltet werden. Auf der der Kontaktfläche gegenüberliegenden Seite ist das Kontaktmittel 322 in einer Hohlkehle 334 geführt. Durch diese Hohlkehle 334 wird das Kontaktmittel verspannt und gleichzeitig können geringe Schiefstellungen ausgeglichen werden.

Mit dem Kontaktmittel 323 ist in FIG 3 noch eine weitere Ausführungsform dargestellt. In diesem Fall ist das Kontaktmittel 323 gleichzeitig Vorspannmittel. Das heißt, durch eine geeignete Formgebung und Einspannung im Modulgehäuse 40 drückt das Kontaktmittel 323 nach dem Zusammenbau unmittelbar auf eine weitere elektrisch leitende Schicht 160.

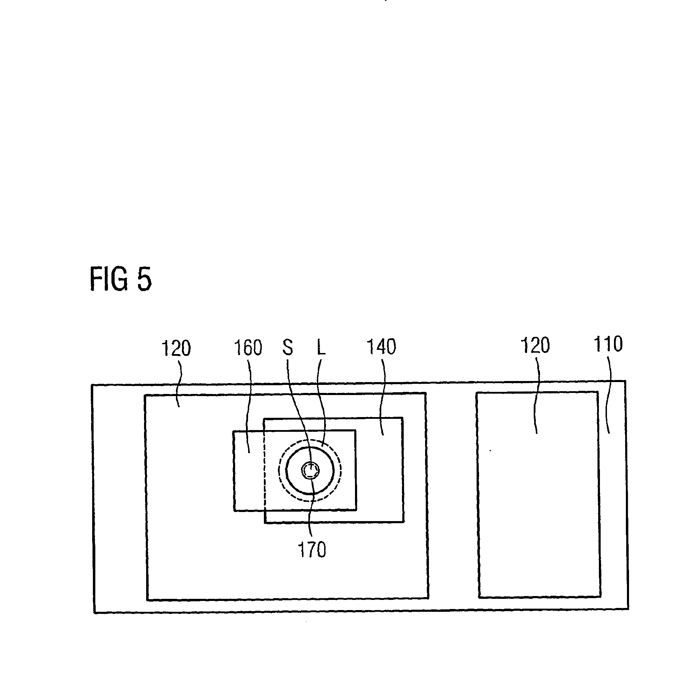

FIG 4 zeigt eine weitere Ausführungsform eines Kontaktmittels 421 des erfindungsgemäßen Halbleiterschaltmoduls 1. Wie in der in FIG 5 dargestellten Draufsicht auf ein Leistungshalbleiterelement 10 angedeutet, ist der Steueranschluss S in aller Regel von dem Lastanschluss L umgeben. Dadurch ist ein, zum Schalten hoher Ströme, üblicherweise benötigter großflächiger Lastanschluss L erzielbar, während für den Steueranschluss S eine kleine Fläche ausreichend ist. Zur Kontaktierung wird nun, wie in FIG 5 dargestellt, mittels Planar-Technologie nur auf den Steueranschluss S des Leistungshalbleiterchips 140 eine dünne, elektrisch leitende Schicht 170 aufgebracht. Typische Schichtdicken sind auch hier 100 bis 200µm. Es wird somit keine planare elektrisch leitende Schicht für die Verbindung des Steueranschlusses S über die restliche Oberfläche des Leistungshalbleiterchips 140 geführt. Die Kontaktierung des Steueranschlusses S erfolgt direkt zum Beispiel mit dem in FIG. 4 dargestellten Steuerkontakt 425, der beispielsweise ein Federkontakt oder eine Bondverbindung sein kann. Erfindungsgemäß muss dazu aber das Kontaktmittel 421 als Hohlkörper ausgebildet sein. So kann die Kontaktfläche A des Hohlkörpers 421 fast vollständig für die Stromzuführung genutzt werden. Die thermischen Verluste durch die Stromzuführung werden minimiert.

Bei all den oben beschriebenen Kontaktierungsarten, seien es die erfindungsgemäßen Druckkontaktierungen der Lastanschlüsse oder auch federnde Anschlüsse der Steueranschlüsse, wirken die durch die Planar-Technologie aufgebrachten weiteren elektrisch leitenden Schichten 160 als Schutzschicht für den Last- und den Steueranschluss. Dadurch können insbesondere die mechanischen Belastungen auf die Anschlüsse reduziert werden. Durch die nahezu senkrechte Kontaktierung lassen sich die größtmöglichen Luft - und Kriechstrecken erreichen. Dies wirkt sich insbesondere in Verbindung mit dem Aufbringen einer Isolierfolie zur Vergrößerung der Luft- und Kriechstrecken vorteilhaft aus.

## Patentansprüche

1. Halbleiterschaltmodul (1)
- mit einem schichtweise ausgeführten Leistungshalbleiterelement (10), das eine Basisschicht (110), eine Kupferschicht (120), zumindest einen auf der Kupferschicht (120) angebrachten Leistungshalbleiterchip (140), eine isolierende Schicht (150), welche zumindest Teile der Oberfläche des Leistungshalbleiterchips (140) und der Kupferschicht (129) abdeckt, und eine weitere elektrisch leitende Schicht (160), welche zumindest einen Lastanschluss (L) des Leistungshalbleiterchips (140) und einen Teil der isolierenden Schicht (150) überdeckt, umfasst,
- mit Mitteln (20,30) zum sicheren Anschließen des Lastanschlusses (L) an einen zu schaltenden Laststromkreis,
- wobei die Mittel (20,30) so ausgebildet sind, dass sie mit einer Kontaktfläche (A) flächig auf die weitere elektrisch leitende Schicht (160) aufdrücken,
**dadurch gekennzeichnet, dass** die Mittel (20,30) zumindest ein elektrisch leitendes Kontaktmittel (20) und ein Vorspannmittel (30) umfassen, wobei das zumindest eine Vorspannmittel das Kontaktmittel auf die weitere leitende Schicht aufdrückt, damit das Kontaktmittel (20) unmittelbar auf der weiteren elektrisch leitenden Schicht (160) aufliegt, welche unmittelbar auf der Fläche des Lastanschlusses (L) aufliegt und somit das Kontaktmittel (20) und der Lastanschluss (L) elektrisch leitend verbunden sind.

2. Halbleiterschaltmodul (1) nach Anspruch 1,
**dadurch gekennzeichnet, dass** die weitere elektrisch leitende Schicht (160) eine Kupferschicht mit einer Schichtdicke von 100 bis 200 µm ist.

3. Halbleiterschaltmodul (1) nach Anspruch 1 oder 2,
**dadurch gekennzeichnet, dass** die Kontaktfläche (A) eine Flächenform ausweist, die mit einer Flächenform des Lastanschlusses (L) korrespondiert, so dass die Kontaktfläche (A) des Kontaktmittels (20) und die Fläche des Lastanschlusses (L) die gleiche Form und den gleichen Flächeninhalt haben, und die Kontaktfläche (A) des Kontaktmittels (20) die Fläche des Lastanschlusses (L) vollständig abdeckt.

4. Halbleiterschaltmodul (1) nach Anspruch 1 oder 2,
**dadurch gekennzeichnet, dass** die weitere elektrisch leitende Schicht (160) so über die Oberfläche des Leistungshalbleiterchips (140) hinaus ausgedehnt ist, dass mit der Kontaktfläche (A) des Kontaktmittels ein flächiger Kontakt neben dem Leistungshalbleiterchip (140) hergestellt ist, wobei zwischen der weiteren elektrisch leitenden Schicht (160) und der Oberfläche der Kupferschicht (120) und des Leistungshalbleiterchips (140) eine elektrisch isolierende Schicht (150) angeordnet ist, die an der Stelle, an der sich der Lastanschluss (L) des Leistungshalbleiterchips (140) befindet, ein Fenster (F) aufweist, um eine Kontaktierung zwischen der weiteren elektrisch leitenden Schicht (160) und dem Lastanschluss (L) herzustellen.

5. Halbleiterschaltmodul (1) nach einem der vorherigen Ansprüche 1 bis 4,
**dadurch** g**ekennzeichnet, dass** das Kontaktmittel (421) als Hohlkörper zum Aufnehmen einer Steuerelektrode (425) ausgebildet ist.

6. Halbleiterschaltmodul (1) nach einem der vorherigen Ansprüche 1 bis 4,
**dadurch gekennzeichnet, dass** das Kontaktmittel (221, 221') zweiteilig ausgebildet ist, wobei die beiden Teile (221, 221') mit einer Wölbungsfläche (W) aneinander zum Liegen kommen.

7. Halbleiterschaltmodul (1) nach einem der Ansprüche 1 bis 6,
**dadurch gekennzeichnet, dass** das Kontaktmittel (121, 221', 321, 421) zumindest eine Verjüngung (128, 228, 328, 428) aufweist.

8. Halbleiterschaltmodul (1) nach einem der Ansprüche 1 bis 7,
**dadurch gekennzeichnet, dass** das Kontaktmittel (121,221,321,322,421) aus weichgeglühtem Kupfer ist.

9. Halbleiterschaltmodul (1) nach einem der Ansprüche 1 bis 8,
**dadurch gekennzeichnet, dass** das Vorspannmittel einen Bügel (130,230,330,430), mit zumindest einer Auswölbung (131,231,331,334,435), und Befestigungsmittel (132,232,332,432) umfasst.

10. Halbleiterschaltmodul (1) nach einem der Ansprüche 1 bis 8,
**dadurch gekennzeichnet, dass** das Vorspannmittel Teil eines Gehäuses des Halbleiterschaltmoduls ist.

11. Halbleiterschaltmodul (1) nach einem der vorherigen Ansprüche 1 bis 4,
**dadurch gekennzeichnet, dass** das Kontaktmittel und das Vorspannmittel einstückig als federndes Kontaktmittel (323) ausgebildet ist.

12. Halbleiterschaltmodul (1) nach einem der vorherigen Ansprüche 1 bis 11,
**dadurch gekennzeichnet, dass** an das Kontaktmittel ein Kabel anschließbar ist.

13. Halbleiterschaltmodul (1) nach einem der vorherigen Ansprüche 1 bis 12,
**dadurch gekennzeichnet, dass** das Kontaktmittel so ausgebildet ist, das es als Wärmespeicher dient.

14. Halbleiterschaltmodul (1) nach einem der vorherigen Ansprüche 1 bis 13,
**dadurch gekennzeichnet, dass** auf der, der Seite mit dem Leistungshalbleiterchip (140) gegenüberliegenden Seite des Leistungshalbleiterelements (10) eine weitere Kupferschicht (130) vorgesehen ist, die mit einem Kühlkörper (50) verbunden ist.

## Claims

1. Semiconductor switching module (1)
- comprising a power semiconductor element (10) embodied in layers and comprising a base layer (110), a copper layer (120), at least one power semiconductor chip (140) fitted on the copper layer (120), an insulating layer (150), which covers at least parts of the surface of the power semiconductor chip (140) and the copper layer (129), and a further electrically conductive layer (160), which covers at least one load terminal (L) of the power semiconductor chip (140) and part of the insulating layer (150),
- comprising means (20, 30) for reliably connecting the load terminal (L) to a load circuit to be switched,
- wherein the means (20, 30) are formed such that they press with a contact area (A) areally onto the further electrically conductive layer (160),
**characterized in that**
the means (20, 30) comprise at least one electrically conductive contact means (20) and one prestress means (30), wherein the at least one prestress means presses the contact means onto the further conductive layer, in order that the contact means (20) bears directly on the further electrically conductive layer (160), which bears directly on the area of the load terminal (L), and the contact means (20) and the load terminal (L) are thus electrically conductively connected.

2. Semiconductor switching module (1) according to Claim 1,
**characterized in that**
the further electrically conductive layer (160) is a copper layer having a layer thickness of 100 to 200 µm.

3. Semiconductor switching module (1) according to Claim 1 or 2,
**characterized in that**
the contact area (A) has an area form corresponding to an area form of the load terminal (L), such that the contact area (A) of the contact means (20) and the area of the load terminal (L) have the same form and the same area content, and the contact area (A) of the contact means (20) completely covers the area of the load terminal (L).

4. Semiconductor switching module (1) according to Claim 1 or 2,
**characterized in that**
the further electrically conductive layer (160) is extended beyond the surface of the power semiconductor chip (140) such that with the contact area (A) of the contact means an areal contact is produced alongside the power semiconductor chip (140), wherein an electrically insulating layer (150) is arranged between the further electrically conductive layer (160) and the surface of the copper layer (120) and of the power semiconductor chip (140), said electrically insulating layer having a window (F) at the location at which the load terminal (L) of the power semiconductor chip (140) is situated, in order to produce a contact-connection between the further electrically conductive layer (160) and the load terminal (L).

5. Semiconductor switching module (1) according to one of the preceding Claims 1 to 4,
**characterized in that**
the contact means (421) is formed as a hollow body for receiving a control electrode (425).

6. Semiconductor switching module (1) according to one of the preceding Claims 1 to 4,
**characterized in that**
the contact means (221, 221') is formed in two parts, wherein the two parts (221, 221') bear against one another with a curvature area (W).

7. Semiconductor switching module (1) according to one of Claims 1 to 6,
**characterized in that**
the contact means (121, 221', 321, 421) has at least one tapering portion (128, 228, 328, 428).

8. Semiconductor switching module (1) according to one of Claims 1 to 7,
**characterized in that**
the contact means (121, 221, 321, 322, 421) is made of soft-annealed copper.

9. Semiconductor switching module (1) according to one of Claims 1 to 8,
**characterized in that**
the prestress means comprises a clip (130, 230, 330, 430), having at least one bulge (131, 231, 331, 334, 435), and fixing means (132, 232, 332, 432).

10. Semiconductor switching module (1) according to one of Claims 1 to 8,
**characterized in that**
the prestress means is part of a housing of the semiconductor switching module.

11. Semiconductor switching module (1) according to one of the preceding Claims 1 to 4,
**characterized in that**
the contact means and the prestress means are formed in one piece as resilient contact means (323).

12. Semiconductor switching module (1) according to one of the preceding Claims 1 to 11,
**characterized in that**
a cable can be connected to the contact means.

13. Semiconductor switching module (1) according to one of the preceding Claims 1 to 12,
**characterized in that**
the contact means is formed in such a way that it serves as a heat accumulator.

14. Semiconductor switching module (1) according to one of the preceding Claims 1 to 13,
**characterized in that**
a further copper layer (130) is provided on that side of the power semiconductor element (10) which is opposite to the side with the power semiconductor chip (140), said further copper layer being connected to a heat sink (50).

## Revendications

1. Module ( 1 ) de commutation à semiconducteur,
- comprenant un élément ( 10 ) à semiconducteur de puissance réalisé couche par couche, qui comprend une couche ( 110 ) de base, une couche ( 120 ) de cuivre, au moins une puce ( 140 ) à semiconducteur de puissance mise sur la couche ( 120 ) de cuivre, une couche ( 150 ) isolante qui recouvre au moins des parties de la surface de la puce ( 140 ) à semiconducteur de puissance et de la couche ( 129 ) de cuivre et une autre couche ( 160 ) conductrice de l'électricité qui recouvre au moins une borne ( L ) de charge de la puce ( 140 ) à semiconducteur de puissance et une partie de la couche ( 150 ) isolante,
- comprenant des moyens ( 20, 30 ) de raccordement sûr de la borne ( L ) de charge à un circuit de charge à commuter,
- dans lequel les moyens ( 20, 30 ) sont tels qu'ils s'appuient par une surface ( A ) de contact à plat sur l'autre couche ( 160 ) conductrice de l'électricité,
**caractérisé en ce que** les moyens ( 20, 30 ) comprennent au moins un moyen ( 20 ) de contact conducteur de l'électricité et un moyen ( 30 ) de précontrainte le au moins un moyen de précontrainte appliquant le moyen de contact sur l'autre couche conductrice afin que le moyen ( 20 ) de contact s'applique directement sur l'autre couche ( 160 ) conductrice de l'électricité qui s'applique directement sur la surface de la borne ( L ) de charge et ainsi le moyen ( 20 ) de contact et la borne ( L ) de charge sont reliés d'une manière conductrice de l'électricité.

2. Module ( 1 ) de commutation à semiconducteur suivant la revendication 1,
**caractérisé en ce que** l'autre couche ( 160 ) conductrice de l'électricité est une couche de cuivre d'une épaisseur de 100 à 200 µm.

3. Module ( 1 ) de commutation à semiconducteur suivant la revendication 1 ou 2,
**caractérisé en ce que** la surface ( A ) de contact a une forme de surface qui correspond à une forme de surface de la borne ( L ) de charge de sorte que la surface ( A ) de contact du moyen ( 20 ) de contact de la surface de la borne ( L ) de charge ont la même forme et la même superficie et la surface ( A ) de contact du moyen ( 20 ) de contact recouvre complètement la surface de la borne ( L ) de charge.

4. Module ( 1 ) de commutation à semiconducteur suivant la revendication 1 ou 2,
**caractérisé en ce que** l'autre couche ( 160 ) conductrice de l'électricité dépasse de la surface de la puce ( 140 ) à semiconducteur de puissance de manière à ménager, par la surface ( A ) de contact du moyen de contact, un contact de surface à côté de la puce ( 140 ) à semiconducteur de puissance, dans lequel il est disposé, entre l'autre couche ( 160 ) conductrice de l'électrice et la surface de la couche ( 120 ) de cuivre et de la puce ( 140 ) à semiconducteur de puissance, une couche ( 150 ) isolante du point de vue électrique qui, à l'endroit où la borne ( L ) de charge de la puce ( 140 ) à semiconducteur de puissance se trouve, comporte une fenêtre ( F ) pour ménager un contact entre l'autre couche ( 160 ) conductrice de l'électricité et la borne ( L ) de charge.

5. Module ( 1 ) de commutation à semiconducteur suivant l'une des revendications précédentes 1 à 4,
**caractérisé en ce que** le moyen ( 421 ) de contact est constitué sous la forme d'un corps creux pour la réception d'une électrode ( 425 ) de commande.

6. Module ( 1 ) de commutation à semiconducteur suivant l'une des revendications précédentes 1 à 4,
**caractérisé en ce que** le moyen ( 221, 221' ) de contact est en deux parties, les deux parties ( 221, 221' ) s'appliquant l'une à l'autre par une surface ( W ) bombée.

7. Module ( 1 ) de commutation à semiconducteur suivant l'une des revendications 1 à 6,
**caractérisé en ce que** le moyen ( 121, 221',321, 421 ) de contact a au moins un rétrécissement ( 128, 228, 328, 428 ).

8. Module ( 1 ) de commutation à semiconducteur suivant l'une des revendications 1 à 7,
**caractérisé en ce que** le moyen ( 121, 221, 321, 322, 421 ) de contact est en cuivre recuit.

9. Module ( 1 ) de commutation à semiconducteur suivant l'une des revendications 1 à 8,
**caractérisé en ce que** le moyen de précontrainte comprend un étrier ( 130, 230, 330, 430 ) ayant au moins une voussure ( 131, 231, 331, 334, 435 ) et un moyen ( 132, 232, 332, 432 ) de fixation.

10. Module ( 1 ) de commutation à semiconducteur suivant l'une des revendications 1 à 8,
**caractérisé en ce que** le moyen de précontrainte fait partie d'un boîtier du module de commutation à semiconducteur.

11. Module ( 1 ) de commutation à semiconducteur suivant l'une des revendications précédentes 1 à 4,
**caractérisé en ce que** le moyen de contact et le moyen de précontrainte sont constitués d'une seule pièce sous la forme d'un moyen ( 323 ) de contact élastique.

12. Module ( 1 ) de commutation à semiconducteur suivant l'une des revendications précédentes 1 à 11,
**caractérisé en ce qu'**un câble peut être raccordé au moyen de contact.

13. Module ( 1 ) de commutation à semiconducteur suivant l'une des revendications 1 à 12,
**caractérisé en ce que** le moyen de contact est tel qu'il sert d'accumulateur de chaleur.

14. Module ( 1 ) de commutation à semiconducteur suivant l'une des revendications précédentes 1 à 13,
**caractérisé en ce qu'**il est prévu, du côté de l'élément ( 10 ) à semiconducteur de puissance opposé au côté ayant la puce ( 140 ) à semiconducteur de puissance, une autre couche ( 130 ) de cuivre qui est reliée à un dissipateur ( 50 ) de chaleur.
